(19)

Europäisches Patentamt

European Patent Office

Office européen des brevets

(11) EP 3 082 263 A1

(12) EUROPEAN PATENT APPLICATION

(43) Date of publication:
19.10.2016 Bulletin 2016/42

(51) Int Cl.:
H03M 1/46 (2006.01)        H03M 1/36 (2006.01)
H02M 3/157 (2006.01)

(21) Application number: 16165025.4

(22) Date of filing: 13.04.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 17.04.2015   DE 102015105880

(71) Applicant: Zentrum Mikroelektronik Dresden AG
01109 Dresden (DE)

(72) Inventor: STACK, David
Limerick (IE)

(74) Representative: Lippert, Stachow & Partner
Patentanwälte
Krenkelstrasse 3
01309 Dresden (DE)

(54) **DIGITALLY ASSISTED CURRENT SENSE CIRCUIT AND METHOD FOR DIGITIZING A SENSED SIGNAL**

(57)     The present disclosure relates to a method for digitizing a sensed signal in a digitally assisted current sense circuit a digitally assisted current sense circuit that uses the disclosed method. The task of the invention to realize a simple way to sense and convert an analogue current signal into a digital signal will be solved by a method comprising the steps of generating a voltage corresponding to a sensed inductor current $I_L$; amplifying and buffering the voltage for creating an input signal to be converted by an analogue-to-digital converter (ADC) and the ADC uses an estimate of the inductor current provided by a modified digital observer circuit as a starting point for an analogue-to-digital conversion. The method is used by a digitally assisted current sense circuit comprising means for generating a voltage corresponding to a sensed inductor current $I_L(t)$, amplifier for amplifying and means for buffering the voltage for creating an input signal to be converted to a corresponding digital signal, an analogue-to-digital converter (ADC) for converting the input signal to the digital signal, and a modified digital observer circuit for providing an estimate of the inductor current $I_L$ as a starting point for the analogue-to-digital conversion of the ADC.

Fig. 1

**Description**

FIELD OF THE INVENTION

The present disclosure relates to a method for digitizing a sensed signal in a digitally assisted current sense circuit.
The present disclosure also relates to a digitally assisted current sense circuit that uses the disclosed method.

BACKGROUND OF THE INVENTION

Current sensing circuits are an important part of digital controllers in dc to dc converters. There are three broad measurement methods that are used in current sense circuits, sense-fets for example by C. F. Lee, P. K. T. Mok, et al. in "A Monolithic Current-Mode CMOS DC - DC Converter With On-Chip Current-Sensing Technique", vol. 39, no. 1, pp. 3-14, 2004, sensorless observer circuits for example by P. Midya, P. T. Krein, and M. F. Greuel, "Sensorless Current Mode Control - An Observer-Based Technique for Dc-Dc Converters", Trans. Power Electron., vol. 16, no. 4, pp. 522-526, 2001 and A. Kelly and K. Rinne, "Sensorless current-mode control of a digital dead-beat DC-DC converter", Ninet. Annu. IEEE Appl. Power Electron. Conf. Expo. 2004. APEC '04., vol. 3, pp. 1790-1795, and voltage drop measurement techniques for example by H. D. C. Dc, M. Supplies, et al., "Lossless Current Sensing in Low-Voltage," IEEE Trans. IDUSTRIAL Electron., vol. 47, no. 6, pp. 1249-1252, 2000.
Each of these methods has different advantages and disadvantages when used with digital power controllers. Sense-fet's require the power fet and the sensing fet to match accurately and hence are limited by needing the digital power controller to be integrated onto the same process as the power-stage, because the two transistors must experience the same effects like temperature, voltage, process variations, and so on and hence must be fabricated on the same chip, or in multi-chip solutions require the use of a power-stage with integrated sense-fets included. Observer circuits synthesize the inductor current from known variables such as input voltage, output voltage and duty cycle but suffer from limited accuracy which can only be improved with tuning circuits for example by A. Prodic, Z. Lukic, et al., "Self -Tuning Digital Current Estimator For Low-Power Switching Converters", pp. 529-534, 2011. While in voltage drop methods the voltage across a known resistance is sensed and used to generate the current. These circuits are also difficult to design as the resistance used is typically small for efficiency reasons and hence a small voltage must be sensed with high accuracy and bandwidth.
From above it can be seen that there is no simple way to sense and convert the current signal. Any method to ease this conversion is of great benefit.

BRIEF SUMMARY OF THE INVENTION

Current sensing circuits are an important part of digital controllers in dc to dc converters. The current sense signal $I_L$ is usually a small voltage $V_{sense}$ which must be digitized with high resolution, accuracy and bandwidth. Hence the analogue-to-digital converters (ADC's) used in these circuits are difficult to design, require significant silicon area and consume high current.
The disclosed invention describes a method to ease the design of the current sense ADC by using a modified digital observer circuit in parallel with the current sense path to provide an estimate of the sensed signal to the ADC. Depending on the ADC architecture used this estimate allows the ADC to use less current, have a smaller area or complete its conversion in less time and hence provides a significant advantage in the design of these circuits.
The present invention relates to a method for digitizing a sensed signal in a digitally assisted current sense circuit comprising the following steps: generating a voltage corresponding to a sensed inductor current; amplifying and buffering the voltage for creating an input signal to be converted by an analogue-to-digital converter (ADC) and the ADC uses an estimate of the inductor current provided by a modified digital observer circuit as a starting point for an analogue-to-digital conversion. The digital observer circuit is modified by using the previous ADC measurement to calculate the present estimate. Typically the previous estimate would be used. But as described later equation 4 is used rather than equation 3.
The modified digital observer circuit is used to estimate the current to be sensed. This estimate is then used by the ADC in the current sense path and this eases the operation of the ADC.
The inductor current is estimated from already known variables such as input voltage, output voltage and duty cycle. Hence the inductor current can be synthesized by a sensor-less digital circuit. One method to realize the estimate of the inductor current involves applying a bi-linear transformation to an I-V-relationship of a voltage across a power inductor whereas the estimate is performed in a controller of the modified digital observer circuit.
The inductor current $I_{L,est}$ can be calculated by the following I-V-relationship:

$$I_{L,est}[n] = \frac{1}{R_L}\left\{\frac{V_L[n]+V_L[n-1]}{\left(1+\frac{2L}{R_L T_s}\right)} + I_{L,est}[n-1]\frac{R_L\left(\frac{2L}{R_L T_s}-1\right)}{\left(1+\frac{2L}{R_L T_s}\right)}\right\} \qquad (1)$$

where $V_L$ is the voltage across the power inductor of inductance value L and dc resistance $R_L$ and $T_S$ is the power converters switching frequency.

To make the above equation practical to use $V_L[n]$ can be replaced with the average voltage across the inductor, $V_{L,ave}[n]$, over one switching period of the converter. This voltage can be approximated by

$$V_{L,ave}[n] = d[n]V_{in}[n] - V_{out}[n] \qquad (2)$$

where d[n] is the duty cycle for the nth period, $V_{in}$ is the sampled input voltage and $V_{out}$ is the sampled output voltage. This then leads to

$$I_{L,est}[n] = \frac{1}{R_L}\left\{\frac{V_{L,ave}[n]+V_{L,ave}[n-1]}{\left(1+\frac{2L}{R_L T_s}\right)} + I_{L,est}[n-1]\frac{R_L\left(\frac{2L}{R_L T_s}-1\right)}{\left(1+\frac{2L}{R_L T_s}\right)}\right\} \qquad (3)$$

The accuracy of the estimated current is mainly compromised by errors in the approximated value for $V_{L,ave}$ due to unknown parasitic resistances such as the power mosfet $R_{dson}$. These errors cause the estimated inductor current and the actual inductor current to diverge. To prevent such divergence the previous inductor current estimate is replaced with the accurate previous adc measurement of the inductor current. The previous inductor current is the current that was determined in the previous clock cycle [n-1], if [n] is the actual clock cycle.

$$I_{L,est}[n] = \frac{1}{R_L}\left\{\frac{V_{L,ave}[n]+V_{L,ave}[n-1]}{\left(1+\frac{2L}{R_L T_s}\right)} + I_L[n-1]\frac{R_L\left(\frac{2L}{R_L T_s}-1\right)}{\left(1+\frac{2L}{R_L T_s}\right)}\right\} \qquad (4)$$

In one embodiment of the invention it is advantageous to use a successive-approximation register analogue-to-digital converter (SAR ADC) that uses a modified data dependent algorithm for the analogue-to-digital conversion whereas the calculated estimate is used as the starting point for the SAR ADC conversion.

Data-dependent SAR ADCs are typically used in situations where the input signal has short periods of high activity as well as long periods of low activity. In these situations the input signal can be well approximated by the previous adc output and hence a data dependent successive approximation algorithm can be used to advantage over a binary search algorithm.

The modified data dependent algorithm uses 4 clock cycles (corresponding to 4 duty cycles) for sampling the input signal. Then RANGE+2 additional clock cycles are used for completing the analogue-to-digital conversion, if the estimate of the inductor current provided by the digital observer circuit is within a range of + /-2$^{RANGE}$ lsbs (last significant bits) of the final result. The purpose of this algorithm is to reduce the number of clock cycles needed per conversion by using the estimate provided by the observer circuit. If the estimate is accurate then the ADC quickly completes the conversion to full resolution however in cases where the estimate is not accurate, such as during transient current ramps, the ADC reduces its resolution and completes the conversion to less accuracy.

That means, if the sampled input falls within the range the SAR ADC completes the analogue-to-digital conversion to the full resolution of the SAR ADC; if the sampled input is outside the range, the SAR ADC widens its search range by a factor of 2 with each further clock cycle and once the range is found where the sampled input falls in the analogue-to-digital conversion is completed to less accuracy.

The variable RANGE is set based on an expected error of the estimator and noise of the sampled inductor current.

The present invention also relates to a digitally assisted current sense circuit comprising means for generating a voltage corresponding to a sensed inductor current; amplifier for amplifying and means for buffering the voltage for creating an input signal to be converted to a corresponding digital signal; an analogue-to-digital converter (ADC) for converting the input signal to the digital signal; and a modified digital observer circuit for providing an estimate of the inductor current as a starting point for the analogue-to-digital conversion of the ADC.

The modified digital observer circuit comprises a controller providing inputs for an input voltage, an output voltage, a clock cycle and a previous inductor current measurement and an output connected to an input of the ADC for forwarding an estimate of the inductor current to the ADC.

In one embodiment of the invention the ADC is a successive-approximation-register analogue-to-digital converter (SAR ADC).

The ADC can also be a flash analogue-to-digital converter (Flash ADC) that uses the modified digital observer circuit for reducing the necessary number of comparators that are needed to convert an analogue signal into a digital signal.

By using the modified digital observer circuit that is connected to the input of the Flash ADC the number of comparators is reduced in comparison to instead of $2^B$-1 comparators that are typically needed in conventional Flash ADCs to realize a conversion of B bits resolution. The modified digital observer uses an estimator.

BRIEF DESCRIPTION OF THE DRAWINGS

Reference will be made to the accompanying drawings, wherein:

Fig. 1     shows a block diagram of the invention;

Fig. 2     shows a block diagram of the current sense circuit;

Fig. 3     shows a SAR ADC operation with estimate within range, wherein RANGE = 3;

Fig. 4     shows a SAR ADC operation with estimate outside range, wherein RANGE = 3;

Fig. 5     shows a circuit operation with a slow input ramp from 0 A to 60 A, with RANGE = 3, $I_{err}$ = 0.29 mArms for $I_{ni,eq}$ = 0.25 Arms;

Fig. 6     shows a circuit operation with a fast current ramp from 20 A to 40 A at 10 A/μS, with RANGE = 3, $I_{err}$ = 0.329 mArms for $I_{ni,eq}$ = 0.25 Arms;

Fig. 7     shows a circuit operation with a fast current ramp from 20 A to 40 A at 10 A/μS, with RANGE = 3, $I_{err,40A}$ = 0.44 A, $I_{err,20A}$ = 0.16 A;

Fig. 8     shows another embodiment of the invention using the inventive modified digital observer circuit in combination with a flash ADC.

DETAILED DESCRIPTION OG THE INVENTION

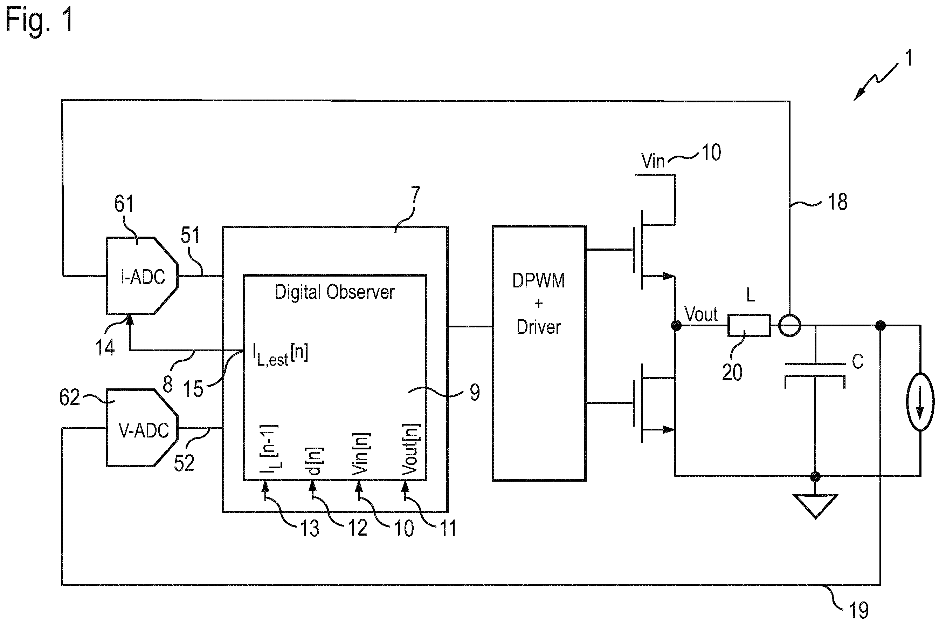

Figure 1 shows the principle operation of the present invention. The method according to the invention eases the design of the current sense ADC 6 by using a modified digital observer circuit 7 in parallel with the current sense path 18, 181, 182 to provide an estimate 8 of the sensed signal to the ADC 6. Depending on the ADC architecture 6, 16, 21 used this estimate 8 allows the ADC to use less current, have a smaller area or complete its conversion in less time and hence provides a significant advantage in the design of these circuits.

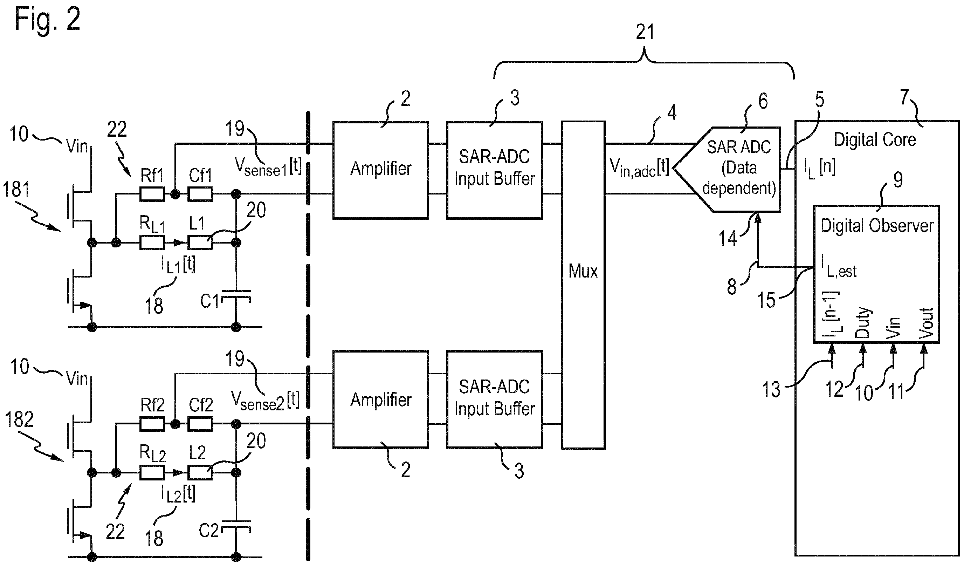

Figure 2 shows a first example of an observer and data dependent SAR ADC 21. A modified digital observer circuit 7 is used to estimate the current 8 to be sensed. This estimate is then used by the ADC 21 in the current sense path 181, 182 and this eases the operation of the ADC 21. Figure 2 shows one possible method to use the invention. In this diagram two current sense paths 181, 182 are shown. The matched filter current sense approach 22 described by H. D. C. Dc, M. Supplies, et al., "Lossless Current Sensing in Low-Voltage," IEEE Trans. IDUSTRIAL Electron., vol. 47, no. 6, pp. 1249-1252, 2000 is used to generate the signals $V_{sense1}$ and $V_{sense2}$ 19 which are scaled versions of the inductor current $I_{L1}$ and $I_{L2}$ 18 if the filter components, $R_{f1}$, $R_{f2}$, $C_{f1}$ and $C_{f2}$ are chosen correctly. The $V_{sense1/2}$ signals 19 are then amplified 2 and buffered 3 to create the signal to be converted by the ADC, $V_{in,adc}$ 4. The ADC used in this case is a data dependent SAR ADC 21 with a modified successive approximation algorithm to take advantage of the estimate provided by the digital observer circuit 7. The combination of inductor current estimate 8 and data dependent SAR ADC allows the conversion time of the ADC to be reduced and hence a SAR ADC running at much lower clock frequency than a SAR using a conventional binary search algorithm can be used to convert the current sense signal of 2 channels to high resolution and bandwidth.

The operation of the modified digital observer circuit 7 is described below in more detail.

Digital observer circuits work by estimating the inductor current $I_L$ from already known variables in the controller 9 such as input voltage 10, output voltage 11 and duty cycle 12. Hence the inductor current can be synthesized by a sensor-less digital circuit. One method to realize the inductor current involves applying the bi-linear transformation to an i-v relationship of the voltage across the power inductor L. This leads to the following equation

$$I_{L,est}[n] = \frac{1}{R_L}\left\{\frac{V_L[n]+V_L[n-1]}{\left(1+\frac{2L}{R_LT_s}\right)} + I_{L,est}[n-1]\frac{R_L\left(\frac{2L}{R_LT_s}-1\right)}{\left(1+\frac{2L}{R_LT_s}\right)}\right\} \qquad (1)$$

Where $V_L$ is the voltage across the power inductor of inductance value L and dc resistance $R_L$, $T_s$ is the power converters switching frequency and $I_{L,est}$ is the estimated inductor current. To make the above equation practical to use we replace $V_L[n]$ with the average voltage across the inductor, $V_{L,ave}[n]$, over one switching period of the converter. This voltage can be approximated by

$$V_{L,ave}[n] = d[n]V_{in}[n] - V_{out}[n] \qquad (2)$$

Where d[n] is the duty cycle for the nth period, $V_{in}$ is the sampled input voltage and $V_{out}$ is the sampled output voltage.
This then leads to

$$I_{L,est}[n] = \frac{1}{R_L}\left\{\frac{V_{L,ave}[n]+V_{L,ave}[n-1]}{\left(1+\frac{2L}{R_LT_s}\right)} + I_{L,est}[n-1]\frac{R_L\left(\frac{2L}{R_LT_s}-1\right)}{\left(1+\frac{2L}{R_LT_s}\right)}\right\} \qquad (3)$$

The accuracy of the estimated current is mainly compromised by errors in the approximated value for $V_{L,ave}$ due to unknown parasitic resistances such as the power mosfet $R_{dson}$. These errors cause the estimated inductor current and the actual inductor current to diverge. To prevent such divergence the previous inductor current estimate is replaced with the accurate previous adc measurement of the inductor current.

$$I_{L,est}[n] = \frac{1}{R_L}\left\{\frac{V_{L,ave}[n]+V_{L,ave}[n-1]}{\left(1+\frac{2L}{R_LT_s}\right)} + I_L[n-1]\frac{R_L\left(\frac{2L}{R_LT_s}-1\right)}{\left(1+\frac{2L}{R_LT_s}\right)}\right\} \qquad (4)$$

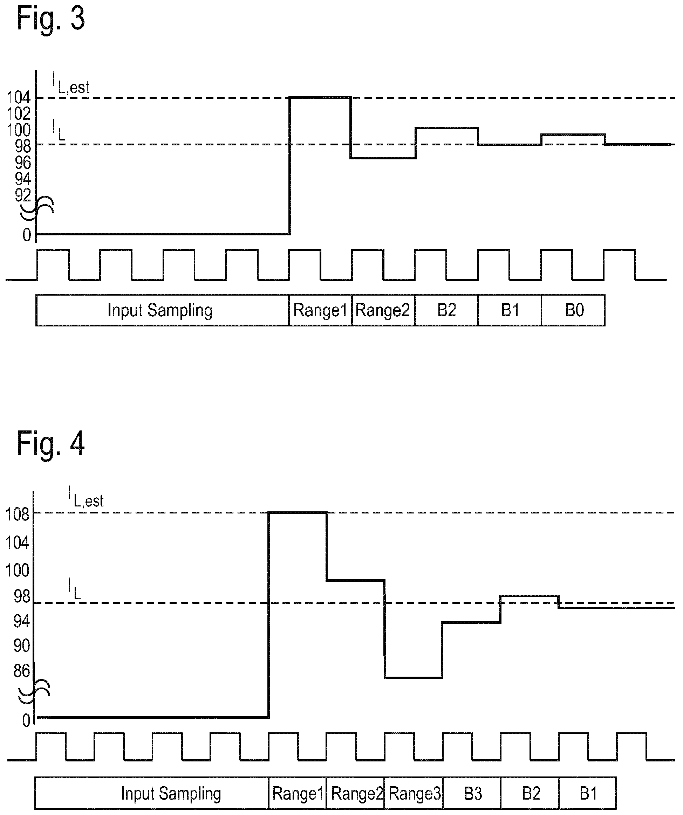

This estimate is then used as the starting point for the SAR ADC conversion.
The operation of the modified data dependent SAR ADC conversion is described below in more detail.
Data-dependent SAR ADCs are typically used in situations where the input signal has short periods of high activity as well as long periods of low activity. In these situations the input signal can be well approximated by the previous adc output and hence a data dependent successive approximation algorithm can be used to advantage over a binary search algorithm.
In the proposed current sense circuit a SAR ADC 21 with modified data dependent algorithm is used. The purpose of this algorithm is to reduce the number of clock cycles needed per conversion by using the estimate 8 provided by the observer circuit 7. If the estimate 8 is accurate then the ADC 21 quickly completes the conversion to full resolution however in cases where the estimate is not accurate, such as during transient current ramps, the ADC reduces its resolution and completes the conversion to less accuracy. In this way one ADC with low frequency clock can be used to digitize the current of 2 current sense channels to high resolution at times when the sensed current is static.
To explain how the algorithm works in detail a 12bit SAR ADC is used. Such an ADC would normally take 16 clock cycles to complete its conversion to 12bit accuracy if 4 cycles are used for input sampling and a further 12 cycles are used for the 12 bit conversion. However with the modified algorithm only (RANGE+2) additional clocks are needed in addition to the sampling phases to complete the conversion to 12 bit accuracy if the estimate provided by the observer circuit is within +/-$2^{RANGE}$ lsbs of the final result. RANGE is set based on the expected error of the estimator and noise of the sampled current. Referring to the example conversion shown in Fig. 3, RANGE is set to 3. In the 2 cycles following input sampling, RANGE1 and RANGE2, it is determined if the input voltage is in the expected range. During RANGE1 cycle, the ADC determines if the sampled input is higher or lower than the estimated value. If for example the estimate is high during RANGE1 the ADC then compares the input against $I_{L,est}[n]$ - $2^{RANGE}$ lsbs during RANGE2. If as expected the sampled input falls within this window the SAR ADC completes the conversion to the full resolution of the SAR ADC as in [6]. However if the sampled input is outside this window, for example during a transient current ramp, the SAR ADC widens its search range by a factor of 2 with each further clock cycle and hence once the range is found the conversion is completed to less accuracy. Figure 4 illustrates this situation where an extra cycle is needed to get the sampled current within range.

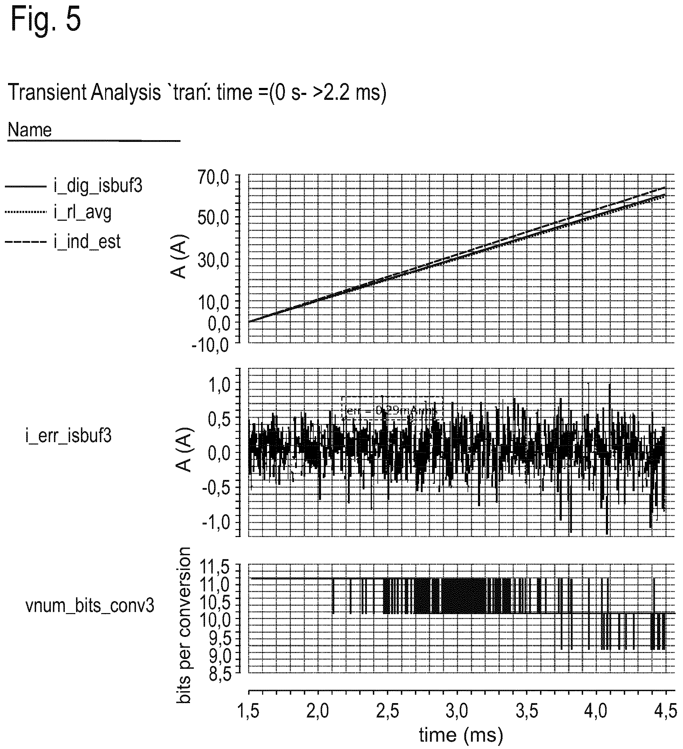

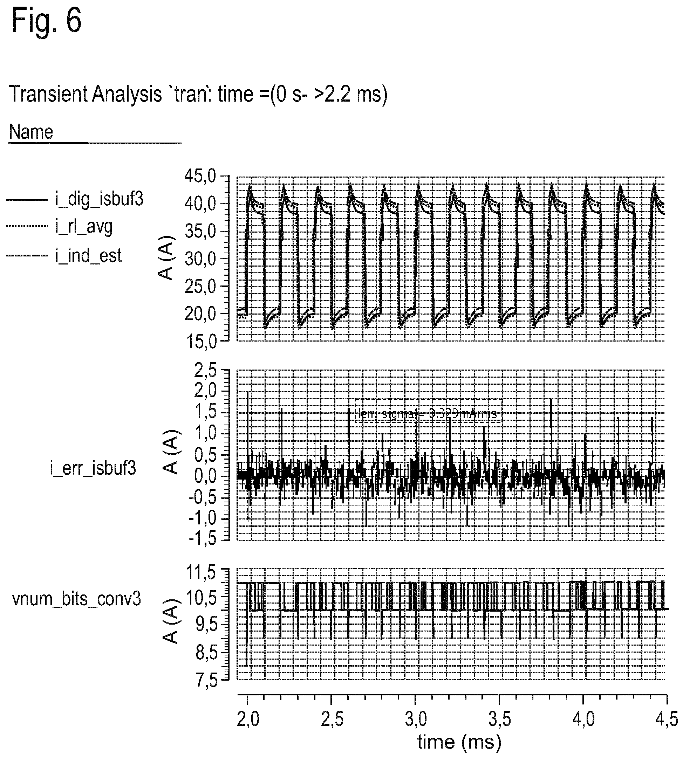

For illustration purposes and for showing the functionality of the present circuit operations figures 5 and 6 show different simulation schemes of the inventive circuit. The following table lists some important simulation parameters. In the following simulations an equivalent input noise of 0.25 Arms has been added to the current sense signal. This is to show the circuit operation with a realistic noise source included.

| Converter Type | VMC |
| --- | --- |
| Input Voltage [V] | 12 |
| Output Voltage [V] | 1 |
| Output Capacitor [F] | 1.14m |
| Output Inductor [H] | 330n |
| Output Inductor DCR [Ohm] | 165u |
| Output Capaciitor ESR [Ohm] | 1.3m |
| Filter resistor. Rf [Ohm] | 900 |
| Filter resistor, Cf [F] | 2.2u |
| Switching Frequency [Hz] | 400k |
| Load Current [A] | 0A - 60A |
| Voltage Sense ADC Isb [V] | 1.4m |
| Voltage Sense ADC sampling freq | 16M |
| Current Sense ADC Isb [A] | 0.25 |
| Current Sense ADC sampling freq | 400k |
| Amplifier Gain [V/V] | 20 |
| Amplifier Bandwidth [Hz] | 500k |
| Ini,eq [Arms] | 0.25 |

Figure 5 shows the circuit operating with a slow 0A to 60A ramp and the RANGE set to 3 so the SAR ADC is allowed 9 clocks to complete its conversion rather than the usual 16. In can be seen from the plot that the estimator and data dependent ADC convert the input current with very little extra errors above those already introduced by the noise signal at the input. In this case for a slow ramp the converted current has a sigma of 0.29mArms for a noise source with equivalent input noise of 0.25mArms. It can also be seen from this plot that as the current increases the estimator error also increases but the conversion accuracy remains constant even though the resolution is being decreased from 11 to 9 bits in some cases.

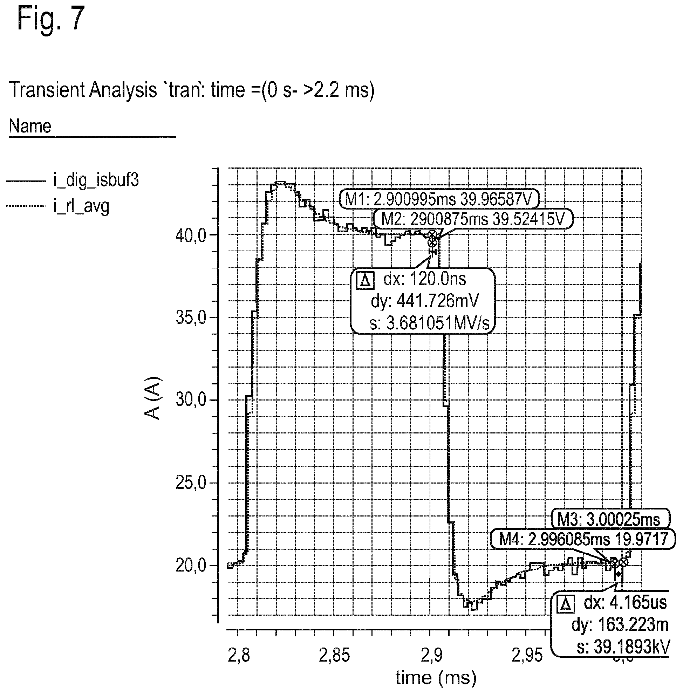

Figure 6 shows the circuit operating with a fast current ramp. Clearly the circuit loses accuracy during the fast current ramp as seen from the spikes in the current error and resolution dropping to 8 bits. Figure 7 zooms in on the static error at 20A and 40A, the error is only 0.16A and 0.44A.

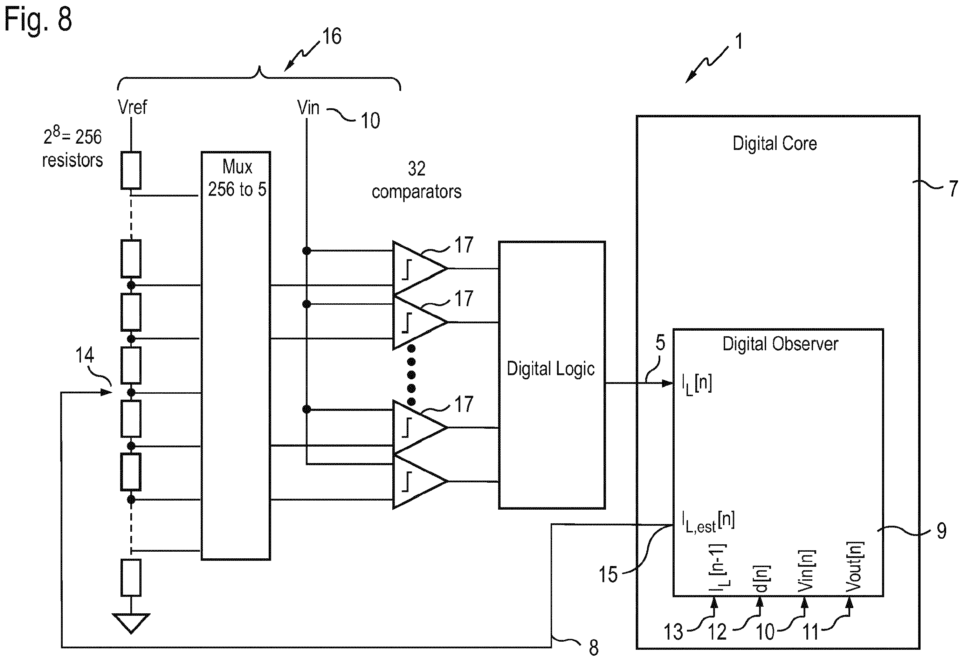

Figure 8 shows another embodiment of the invention using the modified observer circuit 7 in combination with a flash ADC 16 for reducing the necessary number of comparators 17 needed for the analogue-to-digital conversion. Therefore, the estimate 8 from the modified digital observer 7 can be used to reduce the number of comparators 17 needed in a flash ADC 16 used to convert the current signal. A conventional Flash ADC 16 typically requires ($2^B$-1) comparators 17 to realise a flash ADC of B bits resolution. This usually limits the resolution of such ADCs as the area required by the comparators gets too large. Using the estimator however a much smaller number of comparators 17 can be used to complete the conversion as only the levels around the estimated current need to be tested. Figure 8 shows an example where an 8 bit flash ADC is realised with only 32 comparators. Clearly this saves 223 comparators. The reduction in number of comparators depends on the error of the estimator, the desired resolution of the current to be sensed and full scale current to be sensed.

For another example, if a 0.25A resolution should be achieved, and the estimator was accurate to +/-5A and the full scale range was +/- 40A. Then (2*5A/0.25) = 40 comparators are needed with the estimator. With-out the estimator (2*40A/0.25) = 320 comparators are needed. Hence the saving is 280 comparators.

## Reference signs

| | |
|---|---|
| 1 | digitally assisted current sense circuit |
| 2 | amplifier |
| 3 | input buffer |
| 4 | input signal |
| 5 | digital signal |
| 51 | digital signal - current |
| 52 | digital signal - voltage |
| 6 | analogue-to-digital converter (ADC) |
| 61 | analogue-to-digital converter (ADC) - current part |
| 62 | analogue-to-digital converter (ADC) - voltage part |
| 7 | modified digital observer circuit |
| 8 | estimate of the inductor current |
| 9 | digital controller |
| 10 | input voltage |
| 11 | output voltage |
| 12 | clock cycle, duty cycle |
| 13 | previous inductor current |
| 14 | input of the ADC |
| 15 | output of the modified digital observer circuit |
| 16 | flash ADC |
| 17 | comparator |
| 18 | inductor current |
| 181 | current sense path 1 |
| 182 | current sense path 2 |
| 19 | sensed voltage |
| 20 | power inductor |
| 21 | successive approximation register (SAR) ADC |
| 22 | filter |

## Claims

1. Method for digitizing a sensed signal in a digitally assisted current sense circuit (1), the method comprising: generating a voltage corresponding to a sensed inductor current $I_L$ (18); amplifying and buffering the voltage (19) for creating an input signal to be converted by an analogue-to-digital converter (ADC) (6) and the ADC uses an estimate (8) of the inductor current provided by a modified digital observer circuit (7) as a starting point for an analogue-to-digital conversion.

2. The method according to claim 1, wherein the inductor current is estimated from already known variables (10, 11, 12, 13) in a controller (9) of the modified digital observer circuit (7) by applying a bi-linear transformation to an I-V-relationship of a voltage across a power inductor (20).

3. The method according to claim 2, wherein the estimate of the inductor current $I_{L,est}$ (8) can be calculated by the following I-V-relationship:

$$I_{L,est}[n] = \frac{1}{R_L}\left\{ \frac{V_L[n]+V_L[n-1]}{\left(1+\frac{2L}{R_L T_s}\right)} + I_{L,est}[n-1]\frac{R_L\left(\frac{2L}{R_L T_s}-1\right)}{\left(1+\frac{2L}{R_L T_s}\right)} \right\}$$

where $V_L$ is the voltage across the power inductor (20) of inductance value L and dc resistance $R_L$ and $T_s$ is the

power converters switching frequency.

4. The method according to claim 1, wherein the ADC (6) is a successive-approximation-register analogue-to-digital converter (SAR ADC) that uses a modified data dependent algorithm for the analogue-to-digital conversion.

5. The method according to claim 4, wherein the modified data dependent algorithm comprising:

   using 4 clock cycles for sampling the input signal;
   using RANGE+2 additional clock cycles for completing the analogue-to-digital conversion, if the estimate of the inductor current provided by the digital observer circuit is within a range of $+/-2^{RANGE}$ lsbs of the final result.

6. The method according to claim 5, the method comprising:

   if the sampled input falls within the range the SAR ADC completes the analogue-to-digital conversion to the full resolution of the SAR ADC;
   if the sampled input is outside the range, the SAR ADC widens its search range by a factor of 2 with each further clock cycle and once the range is found where the sampled input falls in the analogue-to-digital conversion is completed to less accuracy.

7. The method according to claim 5, wherein RANGE is set based on an expected error of the estimator and noise of the sampled inductor current.

8. Digitally assisted current sense circuit comprising: means for generating a voltage corresponding to a sensed inductor current $I_L(t)$; amplifier (2) for amplifying and means for buffering (3) the voltage for creating an input signal (4) to be converted to a corresponding digital signal (5); an analogue-to-digital converter (ADC) (6) for converting the input signal (4) to the digital signal (5); and a modified digital observer circuit (7) for providing an estimate (8) of the inductor current $I_L$ as a starting point for the analogue-to-digital conversion of the ADC (6).

9. Digitally assisted current sense circuit according to claim 8 wherein the modified digital observer circuit (7) comprises a controller (9) providing inputs for an input voltage (10), an output voltage (11), a clock cycle (12) and a previous inductor current measurement (13) and an output (15) connected to an input (14) of the ADC (6) for forwarding an estimate of the inductor current to the ADC (6).

10. Digitally assisted current sense circuit according to claim 9 wherein the ADC (6) is a successive-approximation-register analogue-to-digital converter (SAR ADC).

11. Digitally assisted current sense circuit according to claim 9 wherein the ADC (6) is a flash analogue-to-digital converter (Flash ADC) (16).

12. Digitally assisted current sense circuit according to claims 9 and 11 wherein the output (15) of the modified digital observer circuit (7) is connected to the input (14) of the Flash ADC (16); wherein a number of comparators (17) needed for the estimation is reduced by using the modified digital observer circuit according to the former claims.

Fig. 1

EP 3 082 263 A1

Fig. 2

EP 3 082 263 A1

Fig. 3

| Input Sampling | Range1 | Range2 | B2 | B1 | B0 |
|---|---|---|---|---|---|

Fig. 4

| Input Sampling | Range1 | Range2 | Range3 | B3 | B2 | B1 |
|---|---|---|---|---|---|---|

11

# Fig. 5

Transient Analysis 'tran': time =(0 s- >2.2 ms)

Name

# Fig. 6

Transient Analysis `tran`: time =(0 s- >2.2 ms)

Name

# Fig. 7

Transient Analysis `tran`: time =(0 s- >2.2 ms)

Name

# Fig. 8

EP 3 082 263 A1

Europäisches
Patentamt

European
Patent Office

Office européen
des brevets

# EUROPEAN SEARCH REPORT

Application Number

EP 16 16 5025

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHAN MAN PUN ET AL: "A Monolithic Digital Ripple-Based Adaptive-Off-Time DC-DC Converter With a Digital Inductor Current Sensor", IEEE JOURNAL OF SOLID-STATE CIRCUITS, IEEE SERVICE CENTER, PISCATAWAY, NJ, USA, vol. 49, no. 8, August 2014 (2014-08), pages 1837-1847, XP011554157, ISSN: 0018-9200, DOI: 10.1109/JSSC.2014.2313567 [retrieved on 2014-07-21] | 1-4,8-12 | INV. H03M1/46 ADD. H03M1/36 H02M3/157 |
| Y | * Section II.A * | 5,7 | |
| A | * Section II.B * * Section III.A * * Section III.B * * Equations (7), (11), (13) and (15) * * figures 3,4,5,9 * | 6 | |
| | ----- | | |
| L | MCCREARY J L ET AL: "AII-MOS CHARGE REDISTRIBUTION ANALOG-TO-DIGITAL CONVERSION TECHNIQUES-PART I", IEEE JOURNAL OF SOLID-STATE CIRCUITS, IEEE SERVICE CENTER, PISCATAWAY, NJ, USA, vol. SC-10, no. 6, December 1975 (1975-12), pages 371-379, XP000916718, ISSN: 0018-9200, DOI: 10.1109/JSSC.1975.1050629 * This document completes the disclosure of Doc #1 with respect to the implementation of a SAR ADC * * the whole document * | 5,7 | |
| | ----- | | |
| | -/-- | | |

TECHNICAL FIELDS SEARCHED (IPC)

H02M
H03M

The present search report has been drawn up for all claims

| Place of search | Date of completion of the search | Examiner |
|---|---|---|
| The Hague | 24 August 2016 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 16 16 5025

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| L | MAN PUN CHAN ET AL: "Design and Implementation of Fully Integrated Digitally Controlled Current-Mode Buck Converter", IEEE TRANSACTIONS ON CIRCUITS AND SYSTEMS I: REGULAR PAPERS, IEEE, US, vol. 58, no. 8, August 2011 (2011-08), pages 1980-1991, XP011480669, ISSN: 1549-8328, DOI: 10.1109/TCSI.2011.2112531 * Section II.B; figure 6 * * This document completes the disclosure of Doc #1 with respect to other known prior art digitally controlled DC-DC converters * | 5,7 | |
| L | SÉBASTIEN CLIQUENNOIS ET AL: "A 65-nm, 1-A Buck Converter With Multi-Function SAR-ADC-Based CCM/PSK Digital Control Loop", IEEE JOURNAL OF SOLID-STATE CIRCUITS, IEEE SERVICE CENTER, PISCATAWAY, NJ, USA, vol. 47, no. 7, July 2012 (2012-07), pages 1546-1556, XP011448469, ISSN: 0018-9200, DOI: 10.1109/JSSC.2012.2191214 * Section III; figure 8 * * This document completes the disclosure of Doc #1 with respect to other known prior art digitally controlled DC-DC converters * | 5,7 | **TECHNICAL FIELDS SEARCHED (IPC)** |

-----

-----

-/--

The present search report has been drawn up for all claims

| Place of search | Date of completion of the search | Examiner |
|---|---|---|
| The Hague | 24 August 2016 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 16 16 5025

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | HAENZSCHE STEFAN ET AL: "A 10 bit 16 MS/s redundant SAR ADC with flexible window function for a digitally controlled DC-DC converter in 28 nm CMOS", 2014 NORCHIP, IEEE, 27 October 2014 (2014-10-27), pages 1-4, XP032715641, DOI: 10.1109/NORCHIP.2014.7004704 [retrieved on 2015-01-07] * Section II * * Section III.A * * Section III.C * * Section IV * * table I * * figures 3,7 * | 5,7 | |
| A | HUEY CHIAN FOONG ET AL: "A 0.8-[mu]W window SAR ADC with offset cancellation for digital DC-DC converters", ANALOG INTEGRATED CIRCUITS AND SIGNAL PROCESSING, KLUWER ACADEMIC PUBLISHERS, BO, vol. 70, no. 1, 17 July 2011 (2011-07-17), pages 133-139, XP019994930, ISSN: 1573-1979, DOI: 10.1007/S10470-011-9702-X * the whole document * | 1-12 | |
| A | HUEY CHIAN FOONG ET AL: "Fast-Transient Integrated Digital DC-DC Converter With Predictive and Feedforward Control", IEEE TRANSACTIONS ON CIRCUITS AND SYSTEMS I: REGULAR PAPERS, IEEE, US, vol. 59, no. 7, July 2012 (2012-07), pages 1567-1576, XP011448552, ISSN: 1549-8328, DOI: 10.1109/TCSI.2011.2177012 * the whole document * | 1-12 | TECHNICAL FIELDS SEARCHED (IPC) |

The present search report has been drawn up for all claims

| Place of search | Date of completion of the search | Examiner |
|---|---|---|
| The Hague | 24 August 2016 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)



**EP 3 082 263 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **C. F. LEE ; P. K. T. MOK et al.** *A Monolithic Current-Mode CMOS DC - DC Converter With On-Chip Current-Sensing Technique,* 2004, vol. 39 (1), 3-14
- **P. MIDYA ; P. T. KREIN ; M. F. GREUEL.** Sensorless Current Mode Control - An Observer-Based Technique for Dc-Dc Converters. *Trans. Power Electron.,* 2001, vol. 16 (4), 522-526
- **A. KELLY ; K. RINNE.** Sensorless current-mode control of a digital dead-beat DC-DC converter. *Ninet. Annu. IEEE Appl. Power Electron. Conf. Expo.,* 2004, vol. 3, 1790-1795
- **H. D. C. DC ; M. SUPPLIES et al.** Lossless Current Sensing in Low-Voltage. *IEEE Trans. IDUSTRIAL Electron.,* 2000, vol. 47 (6), 1249-1252
- **A. PRODIC ; Z. LUKIC et al.** *Self -Tuning Digital Current Estimator For Low-Power Switching Converters,* 2011, 529-534